**Europäisches Patentamt**

**European Patent Office**

**Office européen des brevets**

(19)

(11) Publication number : **0 283 033 B1**

# EUROPEAN PATENT SPECIFICATION

(12)

(45) Date of publication of patent specification :
21.06.95 Bulletin 95/25

(51) Int. Cl.⁶ : **H01F 10/28**, H01F 41/14,
G11B 5/31, C04B 41/85

(21) Application number : 88104358.2

(22) Date of filing : 18.03.88

(54) Ceramic substrate and preparation of the same.

(30) Priority : **20.03.87 JP 66989/87**

(43) Date of publication of application :
**21.09.88 Bulletin 88/38**

(45) Publication of the grant of the patent :
**21.06.95 Bulletin 95/25**

(84) Designated Contracting States :
**DE FR GB**

(56) References cited :
**EP-A- 0 013 363**
**EP-A- 0 108 940**
**EP-A- 0 153 141**
**US-A- 4 659 606**

(73) Proprietor : **SUMITOMO ELECTRIC
INDUSTRIES LIMITED
No. 15, Kitahama 5-chome,
Higashi-ku
Osaka-shi, Osaka 541 (JP)**

(72) Inventor : **Yamakawa, Akira c/o Itami Works of
Sumitomo Electric Industries, Ltd.
1-1 Koyakita 1-chome Itami-shi Hyogo-ken
(JP)**
Inventor : **Igarashi, Tadashi c/o Itami Works of
Sumitomo Electric Industries, Ltd.
1-1 Koyakita 1-chome Itami-shi Hyogo-ken
(JP)**

(74) Representative : **Hansen, Bernd, Dr.rer.nat. et
al
Hoffmann, Eitle & Partner
Patentanwälte
Postfach 81 04 20
D-81904 München (DE)**

EP 0 283 033 B1

## Description

The present invention relates to a method for producing dense ceramic substrate having good workability and mechanical properties.

A ceramic substrate is used widely, for example, as an insulation substrate for integrated circuits, since it has good insulation property and chemical stability. Recently, a thin film magnetic head which is used in a magnetic disk instrument is produced by forming a circuit on the ceramic substrate.

For example, when the ceramic substrate is used as a substrate of the thin film magnetic head as described in U.S. Patent No. 4,660,114 (EP-A-153 141), its surface must be very smooth to such extent that surface roughness $R_{max}$ is about 0.02 $\mu$m so as to form the magnetic circuit. To this end, a dense ceramic base material which comprises aluminum oxide ($Al_2O_3$) and the like as a main component is polished to surface roughness $R_{max}$ of about 0.02 $\mu$m and coated with a ceramic film such as $Al_2O_3$ or $SiO_2$ so as to prepare a substrate, which is used to form a thin film magnetic circuit.

However, even if the surface of the ceramic base material is polished to the surface roughness $R_{max}$ of not larger than about 0.02 $\mu$m, the surface smoothness of the base material has poor reliability and the ceramic film formed on the base material often has poor surface accuracy due to contamination of debris and presence of voids. In addition, the ceramic film cannot be surface finished sufficiently for this use because it cannot be easily machined and tends to suffer from peeling and faults during polishing. Therefore, the ceramic substrate cannot maintain the surface accuracy of the polished ceramic base material and can hardly be used to form the magnetic circuit having desired properties.

EP-A-0 108 940 discloses a thin film magnetic head in which an aluminum oxide film is used for reducing the roughness of the surface. Furthermore, there is known from EP-A-0 013 363 a transducer head in which a permalloy layer is interposed between the base matherail and an amorphous aluminum oxide layer.

An object of the present invention is to provide a method for producing a ceramic substrate which can be easily surface finished with desired surface accuracy for a thin film magnetic head and has high reliability.

The invention is directed to a method for producing a ceramic substrate comprising at least one ceramic base material from the group of $Al_2O_3$, $ZrO_2$, $SiO_2$, SiC, $Si_3N_4$ and AlN and having a porosity of not larger than 1 % and a surface roughness $R_{max}$ of not larger than 0.05 $\mu$m and formed on a surface of said ceramic base material an amorphous aluminum oxide film, wherein said amorphous aluminum oxide film is formed by an ion plating method under a plasma state under the condition that the temperature of the base material is 100 to 500°C up to a thickness in the range of from 1 to 50 $\mu$m and a Vicker's hardness of not larger than 1000 kg/mm$^2$ and a surface roughness $R_{max}$, due to machining by an Elastic Emission Machining Method of not larger than 0.02 $\mu$m.

The ceramic base material comprises at least one selected from $Al_2O_3$, $ZrO_2$, $SiO_2$, SiC, $Si_3N_4$ and $AlN_4$ as a main component. More preferably, it is a densely sintered TiC-containing $Al_2O_3$ or TiC-containing TZP (tetragonal zirconia polycrystal).

When usual ceramic films are used as the film formed on the ceramic base material, they cannot easily surface finished due to their high hardness as described above. When the amorphous aluminum oxide film is used according to the present invention, it has the same smooth surface as the base material due to uniform nucleation and it can be easily and accurately surface finished to surface roughness $R_{max}$ of not larger than 0.02 $\mu$m due to its softness. The hardness (Vickers hardness) of the amorphous aluminum oxide film is controlled to be not larger than 1,000 kg/mm$^2$, since then the surface finishing can easily be carried out.

The amorphous aluminum oxide film is not necessarily a stoichiometric $Al_2O_3$ and it may contain oxygen defect and contaminant elements. The term "amorphous" used herein does not mean that no crystalline phase is contained, but the amorphous aluminum oxide film may contain a small amount of the crystalline phase, for example, which can not be identified by an X-ray analysis. The amorphous aluminum oxide film is prepared by the ion plating method under a plasma state in which the film is quickly formed. This deposition method using the plasma phase is used since the film can be formed at a low temperature at which crystallization can be inhibited, the temperature of the substrate is selected from a wide temperature range, and the resultant amorphous aluminum oxide film has good adhesion properties. Usually, as the temperature of the substrate increases, crystallinity of the film increases and workability of the film is degraded although adhesion of the film to the substrate is improved. Therefore, the upper limit of the temperature of the substrate is such temperature that crystalline aluminum oxide is not identified by the X-ray analysis. The temperature of the substrate is therefore 100 to 500°C.

Although the amorphous aluminum oxide film could be surface finished by a conventional polishing or lapping, it is difficult to obtain repeatedly a fault-free film having the surface roughness $R_{max}$ of not larger than 0.02 $\mu$m. The thin amorphous aluminum oxide film having no fault and the surface roughness $R_{max}$ of not larger than 0.02 $\mu$m to be required for the thin film magnetic head is obtained, when a surface of a work piece is machined by an EEM (Elastic Emission Machining) method in which the surface of the work piece is machined by flowing slurry comprising abrasive grains without contacting the work piece with a rotating lapping tool in the slurry (cf. Mori and Yamauchi, The Journal of the Japan Precision Engineering Society, 51 [1], 12 (1985)). As the abrasive grains, fine powder comprising silicon oxide, aluminum oxide, silicon carbide, diamond, cubic system boron nitride and the like are used. The article diameter of the abrasive grains is smaller than desired surface roughness.

The amorphous aluminum oxide film has a thickness of 1 to 50 μm. When the thickness is smaller than 1 μm, the surface finishing is difficult and the film tends to contain faults. When the thickness is larger than 50 μm, strain in the film increases and the film is expensive.

The present invention is explained by following examples.

Examples 1 to 11

Each base material comprising ceramic sintered body having ingredients shown in Table and a porosity of not more than 1% was polished to surface roughness $R_{max}$ of 0.05 μm by using a diamond paste. The base material had a diameter of 75 mm and a thickness of 4 mm. Then an amorphous aluminum oxide film was formed on a surface of each base material by a procedure shown in Table. The amorphous aluminum oxide film was formed at a substrate temperature of 300°C in an oxygen atmosphere of $5 \times 10^{-4}$ Torr by an ion plating method using a vapor source of $Al_2O_3$ and CVD method.

Each resultant amorphous aluminum oxide film was surface finished according to the EEM method by abrasing the film so as to reduce its thickness by 1 μm in slurry which comprised a dispersion of $SiO_2$ powder of an average particle size of 0.01 μm and was flowed by rotation of a lapping tool. The thickness (μm) and surface roughness $R_{max}$ (Å) of each amorphous aluminum oxide are shown in Table.

Table

| Ex. No. | Base Material | Film type (Procedure) | Thickness of Film | Surface Roughness $10^{-10}$ m |
|---|---|---|---|---|
| 1* | TZP-45TiC | Crystalline (CVD) | 10 μm | 1,000 |
| 2* | ＋ | ＋　　　( ＋ ) | 20 μm | 1,000 |
| 3 | ＋ | Amorphous (Ion Plating) | 20 μm | 30 |
| 4 | ＋ | ＋　　　( ＋ ) | 30 μm | 35 |
| 5* | ＋ | ＋　　　( ＋ ) | 55 μm | 600 |
| 6 | $Al_2O_3$-30TiC | ＋　　　( ＋ ) | 10 μm | 35 |
| 7 | $Si_3N_4$ | ＋　　　( ＋ ) | 10 μm | 35 |
| 8 | SiC | ＋　　　( ＋ ) | 10 μm | 40 |
| 9* | TZP-45TiC | None　( ＋ ) | － | 350 |
| 10* | ＋ | Amorphous　( ＋ ) | 0.5 μm | 250 |
| 11 | AlN | ＋　　　( ＋ ) | 10 μm | 35 |

Note: *) Examples 1, 2, 5, 9 and 10 are Comparative Examples.

Each resultant substrate in Examples according to the present invention has good surface accuracy. In contrast, when no amorphous aluminum oxide film is present (Example 9), the thickness of the amorphous aluminum oxide film is larger than 50 μm (Example 5) and the thickness of the amorphous aluminum oxide film is smaller than 1 μm (Example 10), the surface roughness $R_{max}$ is larger than 0.02 μm and the substrate is not suitable for the ceramic substrate for the thin film magnetic head. When the aluminum oxide film is crystalline (Examples 1 and 2), the surface finishing is difficult and the required surface accuracy cannot be obtained due to, for example, peeling of the film.

## Claims

1. A method for producing a ceramic substrate comprising at least one ceramic base material from the group of $Al_2O_3$, $ZrO_2$, $SiO_2$, SiC, $Si_3N_4$ and AlN and having a porosity of not larger than 1 % and a surface roughness $R_{max}$ of not larger than 0.05 μm and formed on a surface of said ceramic base material an amorphous aluminum oxide film, wherein said amorphous aluminum oxide film is formed by an ion plating method under a plasma state under the condition that the temperature of the base material is 100 to 500°C up to a thickness in the range of from 1 to 50 μm and a Vicker's hardness of not larger than 1000 kg/mm² and a surface roughness $R_{max}$, due to machining by an Elastic Emission Machining Method of not larger than 0.02 μm.

## Patentansprüche

1. Verfahren zur Herstellung eines keramischen Substrates, umfassend wenigstens ein keramisches Grundmaterial aus der Gruppe $Al_2O_3$, $ZrO_2$, $SiO_2$, SiC, $Si_3N_4$ und AlN mit einer Porosität von nicht mehr als 1 % und einer Oberflächenrauhheit $R_{max}$ von nicht größer als 0,05 μm und eines an der Oberfläche des keramischen Grundmaterials gebildeten amorphen Aluminiumoxidfilms, wobei der amorphe Aluminiumoxidfilm durch eine Ionenplattierungsmethode im Plasmazustand gebildet wurde unter der Bedingung, daß die Temperatur des Grundmaterials 100 bis 500°C beträgt und der Film eine Dicke im Bereich von 1 bis 50/um hat und eine Vicker's Härte von nicht mehr als 1000 kg/mm² und eine Oberflächenrauheit $R_{max}$ aufgrund der Bearbeitung mittels einer elastischen Emissionsbearbeitungsmethode von nicht größer als 0,02 μm.

## Revendications

1. Procédé de production d'un substrat en céramique comprenant au moins un matériau de base en céramique du groupe constitué de $Al_2O_3$, $ZrO_2$, $SiO_2$, SiC, $Si_3N_4$ et AlN et présentant une porosité qui n'est pas supérieure à 1 % et une profondeur de rugosité de sufface $R_{max}$ qui n'est pas supérieure à 0,05 μm, et, formée sur une surface dudit matériau de base en céramique, une couche d'oxyde d'aluminium amorphe, dans lequel ladite couche d'oxyde d'aluminium amorphe est formée par un procédé de plaquage ionique dans un état de plasma sous la condition que la température du matériau de base est de 100 à 500°C jusqu'à une épaisseur dans l'intervalle de 1 à 50 μm et que la dureté Vickers n'est pas supérieure à 1000 kg/mm² et que la profondeur de rugosité de surface $R_{max}$, due à un usinage par un procédé d'usinage par émission élastique, n'est pas supérieure à 0,02 μm.